# EUROPÄISCHE PATENTSCHRIFT

(11) **EP 3 769 097 B1**
(45) Veröffentlichungstag und Bekanntmachung des Hinweises auf die Patenterteilung: **02.03.2022**
(21) Anmeldenummer: 19701092.9
(22) Anmeldetag: 18.01.2019
(51) Int. Cl.: G01R 31/11

(54) **MESSANORDNUNG SOWIE VERFAHREN ZUR ÜBERWACHUNG EINES KABELS**
MEASURING ARRANGEMENT AND METHOD FOR MONITORING A CABLE
ENSEMBLE DE MESURE ET PROCÉDÉ POUR SURVEILLER UN CÂBLE

(30) Priorität: 19.03.2018 DE 102018204174
(43) Veröffentlichungstag der Anmeldung: 27.01.2021
(73) Patentinhaber: LEONI Kabel GmbH, 91154 Roth (DE)
(72) Erfinder: JANSSEN, Bernd, 26169 Friesoythe OT Neuscharrel (DE); WEBER, Heiko, 26845 Nortmoor (DE)
(74) Vertreter: FDST Patentanwälte
(86) Internationale Anmeldenummer: PCT/EP2019/051218
(87) Internationale Veröffentlichungsnummer: WO 2019/179671

(56) Entgegenhaltungen:
- EP-A1- 3 285 077
- WO-A1-2017/216061
- DE-A1-102013 227 051
- US-A1- 2011 015 882
- US-A1- 2013 162 262

## Beschreibung

Die Erfindung betrifft eine Messanordnung sowie ein Verfahren zur Überwachung eines Kabels.

Kabel dienen beispielsweise der Übertragung von Energie und/ oder Signalen und weisen hierzu zumindest eine Ader, üblicherweise mehrere Adern, dass heißt isolierte Leiter auf. Mehrere Adern sind oftmals mittels eines gemeinsamen Leitungsmantels zu einem Leitungselement zusammengefasst. Ein Kabel, insbesondere im Bereich der Datenübertragung weist üblicherweise mehrere Leitungselemente auf. Speziell bei Daten - oder Signalleitungen sind häufig noch Schirmlagen ausgebildet. Bei vielen Anwendungen beispielsweise im Automotiv-Bereich unterliegen Kabel diversen Belastungen, welche bezüglich Dauer und Stärke unbekannt sind. Auch die häufig variierenden Umgebungsbedingungen, zum Beispiel Wärmeeinflüsse, können oftmals nicht oder nicht hinreichend abgeschätzt werden, um den Verschleiß eines Kabels vorhersagen zu können. Daneben unterliegen die Kabel häufig auch einer mechanischen Belastung, beispielsweise durch Vibrationen, welche zu einer Beschädigung führen können. Um eine bestimmte Mindestlebensdauer garantieren zu können, werden Kabel und insbesondere die Leitungselemente daher typischerweise überdimensioniert ausgelegt. Alternativ besteht auch die Möglichkeit, das Kabel im Betrieb oder zumindest in regelmäßigen Abständigen zu überwachen und zu kontrollieren.

Aus der WO 2017/216061 A1 ist ein Verfahren zur Überwachung einer Leitung zu entnehmen, bei dem Messimpulse in ein Leitungselement der Leitung eingespeist werden und eine Überlagerung von reflektierten Anteilen der Messimpulse mit den eingespeisten Messimpulsen ausgewertet wird.

Weitere Verfahren zur Überwachung von Leitungen, bei denen in die Leitung ein Messsignal eingespeist wird, sind zum Beispiel zu entnehmen aus US 2013/162262 A, EP 3 285 077 A1, US 2011/0015882 A1 oder DE 10 2013 227 051 A1.

Insbesondere bei Kabeln, die mehrere Leitungselemente mit mehreren Adern aufweisen, gestaltet sich eine derartige Überwachung als aufwändig. Ein weiterer Aspekt derartiger Kabel ist, dass eine Übertragung von elektrischen Daten (beispielsweise Cat5-Kabel) oder elektrischer Leistung nicht durch eine Überwachung gestört oder beeinträchtigt werden soll. Grundsätzlich ist es möglich, derartige Kabel und insbesondere deren Leitungselemente zu überwachen und zu vermessen, jedoch ist ein dafür notwendiges Trennen der Leitungselemente von einem Anschluss, z.B. einem Stecker, sehr aufwändig.

Ausgehend hiervon liegt der Erfindung die Aufgabe zugrunde, eine Messanordnung sowie ein Verfahren anzugeben, mit deren Hilfe ein Kabel einfach und aufwandsarm überwacht werden kann.

Die auf die Messanordnung gerichtete Aufgabe wird erfindungsgemäß gelöst durch eine Messanordnung zur Überwachung eines sich in eine Längsrichtung erstreckenden Kabels.

Das Kabel weist dabei einen Kabelkern mit zumindest einem elektrischen Leitungselement auf. Das Leitungselement dient der Übertragung von elektrischen Daten oder elektrischer Leistung. Das Leitungselement ist vorliegend als Datenleitung oder als Versorgungsleitung ausgebildet. Bevorzugt ist das Leitungselement als Datenleitung ausgebildet, über die im Betrieb Daten, insbesondere Hochfrequenz-Signale (mit einer Frequenz im Bereich von mehreren MHz) übertragen werden.

Weiterhin weist das Kabel eine Signaleinheit auf zur Einspeisung eines Messsignals in den Kabelkern sowie zur Erfassung eines Antwortsignals. Unter dem Antwortsignal wird vorliegend speziell ein mit dem Messsignal korreliertes und durch die Eigenschaften des Kabels beeinflussbares Signal verstanden. Unter Eigenschaften des Kabels werden vorliegend zusammenfassend sowohl elektrische Eigenschaften, z.B. der Wellenwiderstand als auch mechanische (speziell besondere) Eigenschaften wie beispielsweise Beschädigungen verstanden.

Weiterhin ist eine Sensoreinheit mit einer sich in Längsrichtung erstreckenden Sensorleitung sowie mit einer Überwachungseinheit vorgesehen. Die Sensorleitung ist innerhalb des Kabelkerns angeordnet. Die Überwachungseinheit ist dazu ausgebildet, Übertragungspausen des zumindest einen Leitungselements zu erkennen. Unter Übertragungspausen werden vorliegend Zeitspannen verstanden, in denen über das zumindest eine Leitungselement keine Übertragung stattfindet. D.h. während den Übertagungspausen wird über das Kabel und insbesondere über das zumindest eine Leitungselement weder elektrische Daten noch elektrische Leistung übertragen.

Die Signaleinheit ist zur Einspeisung des Messsignals mit dem zumindest einen Leitungselement elektrisch verbunden. Zudem ist die Signaleinheit derart ausgebildet, dass im Betrieb in Abhängigkeit der erfassten Übertragungspausen das Messsignal in das zumindest eine Leitungselement eingespeist wird. Das Antwortsignal wird hierbei erfasst und zur Auswertung an eine Auswerteeinheit übertragen. Die Auswerteeinheit ist bevorzugt in einer gemeinsamen Baueinheit mit der Signaleinheit integriert. Alternativ ist die Auswerteeinheit entfernt von der Signaleinheit, z.B. in einer übergeordneten Steuereinheit beispielsweise eines Kraftfahrzeuges oder einer Wartungszentrale angeordnet.

Das Messsignal wird lediglich dann in das zumindest eine Leitungselement eingespeist, wenn gerade eine Übertagungspause stattfindet, also keine elektrische Daten oder elektrische Leistung übertragen werden. Die Überwachungseinheit ist hierbei beispielsweise derart ausgebildet, dass sie an die Signaleinheit ein Signal übermittelt, wenn seit einer vorgegebenen Zeit, vorzugsweise > 5 Sekunden, insbesondere > 15 und beispielsweise 30 Sekunden, keine Übertragung mehr stattfand. Die Messanordnung geht dann von einer Übertragungspause aus und die Signaleinheit speist daraufhin das Messsignal in das zumindest eine Leitungselement ein und führt eine Messung durch. Startet die Übertragung durch das zumindest eine Leitungselement während der Messung erneut, wird dies von der Überwachungseinheit erkannt, insbesondere erfasst und ein Signal an die Signaleinheit ausgegeben, die daraufhin die Einspeisung des Messsignals stoppt.

Hierdurch ist ein Stören der Daten- oder Leistungsübertagung durch das Messsignal verhindert. Die Signaleinheit und die Überwachungseinheit sind hierbei anwendungsspezifisch beispielsweise im Hinblick zu erwartender Übertragungspausen konfigurierbar. D.h. es kann vorliegend für eine Überwachung des Kabels unabhängig der auftretenden Übertragungspausen die zuvor beschriebene Messanordnung herangezogen werden. Die Übertragungspausen können hierbei entweder von der bereits erwähnten Überwachungseinheit erkannt werden oder anwendungsspezifisch, beispielsweise in Form einer vorgegebenen Uhrzeit oder eines vorgegebenen Datums, z.B.: in einem vorzugsweise internen Speicher der Signaleinheit hinterlegt sein.

Hierdurch ist es ermöglicht, ein Kabel insbesondere im Betrieb zu überwachen. Es werden hierbei im Normalbetrieb auftretende Übertragungspausen für die Einspeisung des Messsignals und somit einer Zustandsmessung des Kabels herangezogen. Der Normalbetrieb und somit die Übertragung des Kabels wird hierbei nicht beeinflusst oder gestört.

Bevorzugt weist der Kabelkern einen Außenschirm auf. Der Außenschirm des Kabelkerns ist vorzugsweise über die Überwachungseinheit mit der Sensorleitung elektrisch verbunden. Hierdurch ist eine Art Koaxialverschaltung mit der Sensorleitung als Innenleiter und dem Außenschirm als Außenleiter realisiert. Aufgrund dieser Ausgestaltung ist mittels der Überwachungseinheit ein Nebensprechsignal des insbesondere ungeschirmten Leitungselements bei einer Übertragung erfassbar. Das Nebensprechen ist ein grundsätzlich bekannter und üblicherweise unerwünschter Effekt, der bei der Datenübertragung auftreten kann. Das Nebensprechen tritt in Folge von Wechselfeldern bei der Übertragung von Daten aber auch bei Wechselfeldern auf. Das Nebensprechsignal tritt also lediglich dann auf, wenn mittels des zumindest einen Leitungselements eine Übertragung stattfindet. Aufgrund dessen, deutet ein erfasstes Nebensprechsignal auf eine Übertragung hin. Mit anderen Worten: Es ist vorliegend explizit eine Einkopplung eines derartigen Nebensprechsignals in den Außenschirm ausgenutzt, um aufgrund dessen im Gegenzug die Übertragungspausen bestimmen zu können.

Gemäß einer zweckdienlichen Ausgestaltung weist die Sensorleitung einen Innenleiter und einen Außenleiter auf. Zwischen dem Innenleiter und dem Außenleiter ist vorzugsweise ein Dielektrikum angeordnet, welches bevorzugt von eier Zustandsgröße, insbesondere der Temperatur abhängig ist.

Gemäß einer bevorzugten Weiterbildung ist der Außenleiter sowohl mit der Signaleinheit als auch mit der Überwachungseinheit verbunden und dient einer Erfassung und Auswertung der Zustandsgröße, insbesondere der Temperatur. Hierdurch ist auf einfache Weise eine Zustandsgrößenmessung, insbesondere eine Temperaturmessung innerhalb des Kabels integriert. Alternativ erfolgen die Erfassung und die Auswertung der Zustandsgröße, insbesondere der Temperatur in einer externen Auswerteeinheit und somit vorzugsweise unabhängig von der Signaleinheit.

Gemäß einer bevorzugten Ausgestaltung weist der Kabelkern mehrere Leitungselemente auf, die jeweils mit der Signaleinheit elektrisch verbunden sind. In den Übertragungspausen wird somit das Messsignal von der Signaleinheit in ein jeweiliges Leitungselement eingespeist. D.h. das Messsignal wird vorzugsweise nacheinander in die jeweiligen Leitungselemente eingespeist, also bevorzugt nicht gleichzeitig.

Weiterhin bevorzugt weist die Signaleinheit ein Umschaltelement, beispielsweise ein Halbleiter-Umschalter nach Art eines integrierten Schaltkreises (integrated circuit, IC) auf. Die Leitungselemente sind hierbei mittels des Umschaltelements mit der Signaleinheit verbunden. Der Vorteil dieser Ausgestaltung ist, dass durch das Umschaltelement im Betrieb das Messsignal abwechselnd in die Leitungselemente einspeisbar ist. Es kann somit ein einziger Eingang, an den das Messsignal angelegt ist, auf die einzelnen Leitungselemente geschaltet werden, was den Verschaltungsaufwand im Rahmen der Fertigung der Messanordnung deutlich reduziert.

Zweckdienlicherweise weist die Überwachungseinheit einen Komparator auf. Unter Komparator wird vorliegend beispielsweise eine elektrische Schaltung verstanden, die zwei elektrische Spannungen miteinander vergleicht. Bei den beiden elektrischen Spannungen handelt es sich vorliegend zum Einen um das erfasste, in den Außenschirm eingekoppelte Nebensprechsignal und zum Anderen um eine Vergleichsspannung, insbesondere um einen Vergleichsspannungswert, der als Maß für eine stattfindenden Übertragung dient. D.h. wird im Betrieb ein Nebensprechsignal in den Außenschirm und somit auch in den Komparator eingekoppelt, dessen Wert größer ist, als der vorgegebene Wert der Vergleichsspannung, so detektiert die Überwachungseinheit eine Übertragung von Daten oder Leistung durch das zumindest eine Leitungselement. Sinkt der Wert des eingekoppelten Nebensprechsignals unter den vorgegebenen Wert der Vergleichsspannung oder erfasst die Überwachungseinheit kein eingekoppeltes Nebensprechsignal, so findet keine Übertragung durch das zumindest eine Leitungselement statt.

Die Empfindlichkeit des Komparators, also der Wert der Vergleichsspannung ist vorzugsweise auf einen Pegel des zu erwartenden eingekoppelten Nebensprechsignals anzupassen, um eine zuverlässige Detektion der Übertragungspausen sicher zu stellen. Eine derartige Anpassung erfolgt vorzugsweise anwendungsspezifisch und flexibel, beispielsweise softwarebasiert im Rahmen einer Inbetriebnahme, einer Fertigung oder im Betrieb der Messanordnung. Somit ist auch eine Erfassung von Übertragungspausen bei unterschiedlichen Daten- oder Leistungsübertragungen realisiert.

Bevorzugt dient die Sensorleitung, insbesondere der Außenleiter als Rückleiter für das Antwortsignal zur Signaleinheit, insbesondere für den reflektierten Messsignalanteil.

Zweckdienlicherweise ist das Antwortsignal ein von dem Kabelkern, insbesondere von dem zumindest einen Leitungselement zur Signaleinheit reflektierter Messsignalanteil. Der Messsignalanteil wird typischerweise an Stellen des Kabels reflektiert, die eine Beschädigung, beispielsweise einen Bruch aufweisen. Somit kann der reflektierte Messsignalanteil zu einer Aussage über einen Zustand des Kabels herangezogen werden.

Die Auswertung des reflektierten Messsignalanteils erfolgt hierbei vorzugsweise unter Berücksichtigung einer bekannten (Signal-)Dämpfung in dem zumindest einen Leitungselement und/oder dem Außenleiter der Sensorleitung. Mit anderen Worten wird bei der Auswertung eine Reduzierung der Signalamplitude des Messsignals oder des reflektierten Messsignalanteils aufgrund einer Ausbreitungsstrecke im Leitungselement berücksichtigt.

Durch Auswertung der (Signal-)Laufzeit zwischen dem Einspeisen des Messsignals und der Ankunft des reflektierten Messsignalanteils ist es möglich, auf den Ort der beschädigten Stelle am Kabel zurückzuschließen. Bei dem Messsignal handelt es sich insbesondere um einen Messimpuls, insbesondere nach Art eines Spannungssprungs oder einer Spannungsstufe. Die Zeitdauer des Messsignals oder Messimpuls ist dabei vorzugsweise größer oder gleich einer zu erwartenden Laufzeit des Messsignals vom Einspeiseort zu einem Ende des zumindest einen Leitungselements und wieder zurück zum Einspeiseort. Dadurch ist sichergestellt, dass ein reflektierter Messsignalanteil am Einspeiseort zur eingespeisten (konstanten) Spannungsamplitude überlagert wird.

Für eine ortsaufgelöste Messung oder zur Auswertung und/oder Bestimmung der Position einer lokalen beschädigten Stelle am Kabel ist eine Laufzeitmessung, beispielsweise in Form einer Zeitbereichsreflektometrie, kurz TDR (Time Domain Reflectometry), möglich. Hierbei wird ein Messimpuls in das zumindest eine Leitungselement eingespeist und der Spannungsverlauf des reflektierten Signalanteils ausgewertet.

Alternativ zu einer TDR-Messung wird ein Messverfahren verwendet, wie es in der zum Anmeldezeitpunkt noch unveröffentlichten internationalen Anmeldung der Anmelderin vom 30.10.2017 mit dem Aktenzeichen PCT/EP 2017/077828 beschrieben ist. Speziell wird Bezug genommen auf die Ansprüche 1,2, 6,7 und 12 mit den zugehörigen Ausführungen speziell auf Seiten 5/6 sowie 8/9. Hierbei werden im Zuge eines Messzyklus mehrere Einzelmessungen durchgeführt, wobei pro Einzelmessung ein Messsignal von der Signaleinheit in das zumindest eine Leitungselement eingespeist wird, wobei bei einem Überschreiten eines vorgegebenen (Spannungs-)Schwellwerts (am Einspeiseort) infolge des reflektierten Messsignalanteils ein Stoppsignal erzeugt wird, wobei eine Laufzeit zwischen dem Einspeisen des Messsignals und dem Stoppsignal ermittelt wird, und wobei der (Spannungs-)Schwellwert zwischen den Einzelmessungen verändert wird.

Zu jeder Einzelmessung wird daher genau ein Stoppsignal erzeugt. Aufgrund des zwischen den Einzelmessungen veränderten Schwellwerts werden unterschiedliche Störstellen (die vorliegend genannten beschädigten Stellen am Kabel), welche somit zu unterschiedlich hohen Amplituden bei der Reflektion führen - durch die unterschiedlichen Laufzeiten örtlich aufgelöst erfasst. Mit anderen Worten werden die Abstands- oder Impedanzänderungen der Sensorleitung entlang des Kabelkerns örtlich aufgelöst erfasst. Somit ist durch die Laufzeit eine Positionsbestimmung der beschädigten Stelle, sowie durch die Auswertung der Anzahl und Größe der Impedanzänderungen das Ausmaß der beschädigten Stelle bestimmbar. Durch die Vielzahl der Einzelmessungen werden daher allgemein zu unterschiedlichen definierten Schwellwerten die Laufzeiten (Stoppsignale) der reflektierten Anteile erfasst. Insofern kann dieses Verfahren als ein spannungsdiskretes Zeitmessverfahren angesehen werden. Die Zahl der Einzelmessungen liegt dabei bevorzugt über 10, weiter bevorzugt über 20 oder auch über 50 und beispielsweise bis zu 100 oder auch mehr Einzelmessungen. Aus der Vielzahl dieser Einzelmessungen wird also eine Vielzahl von Stoppsignalen ermittelt, die zeitlich verteilt angeordnet sind. Die Vielzahl der Stoppsignale in Verbindung mit den Schwellwerten gibt daher näherungsweise den tatsächlichen Signalverlauf des eingespeisten Messsignals und der reflektierten Anteile wieder.

Zur Erfassung der Überschreitung des Schwellwertes ist dabei insbesondere ein Komparator integriert.

Durch die Vielzahl der Einzelmessungen werden daher allgemein zu unterschiedlichen definierten Schwellwerten die Laufzeiten (Stoppsignale) der reflektierten Messsignalanteile erfasst. Insofern kann dieses Verfahren als ein spannungsdiskretes Zeitmessverfahren angesehen werden. Die Zahl der Einzelmessungen liegt dabei bevorzugt über 10, weiter bevorzugt über 20 oder auch über 50 und beispielsweise bis zu 100 oder auch mehr Einzelmessungen.

Alternativ kann durch das in der PCT/EP 2017/077828 beschriebene Messverfahren auch die Funktion des Komparators realisiert werden, um die Übertragungspausen zu erkennen und zu überwachen. Speziell wird der zuvor genannte Komparator zur Erfassung einer Überschreitung des Schwellwertes verwendet.

Gemäß einer bevorzugten Ausgestaltung weist das zumindest eine Leitungselement ein ungeschirmtes Adernpaar, vorzugsweise ein verseiltes ungeschirmtes Adernpaar nach Art einer twisted-pair-Leitung auf. Bei dem Leitungselement und insbesondere bei dem Kabel handelt es sich vorzugsweise um ein insbesondere reines Datenkabel, beispielsweise nach Art eines Cat5-Kabels.

Zweckdienlicherweise ist die Sensorleitung zentral um Kabelkern angeordnet und von dem zumindest einen Leitungselement umgeben. Dieser Ausgestaltung liegt die Überlegung zugrunde, dass somit das Nebensprechsignal während einer Übertragung optimal durch die Überwachungseinheit erfasst werden kann. Die insbesondere ungeschirmte Ausgestaltung des zumindest einen Leitungselements trägt weiterhin vorteilhaft hierzu bei, da das Nebensprechsignal - gewollt - nicht abgeschirmt wird.

Die auf das Verfahren gerichtete Aufgabe wird gelöst durch ein Verfahren zur Überwachung eines sich in eine Längsrichtung erstreckenden Kabels mit Hilfe einer Messanordnung. Bei dem Kabel handelt es sich um das bereits zuvor beschriebene Kabel mit einem Kabelkern mit zumindest einem Leitungselement. Bei der Messanordnung handelt es sich um die bereits im Rahmen dieser Anmeldung beschriebene Messanordnung.

Bei dem Verfahren werden Übertragungspausen in der Übertragung der elektrischen Daten oder der elektrischen Leitung erkannt und erfasst und das Messsignal in Abhängigkeit der erfassten Übertragungspausen in das zumindest eine Leitungselement eingespeist. Das Antwortsignal, insbesondere ein reflektierter Messsignalanteil wird erfasst und zur Auswertung an eine Auswerteeinheit übertragen.

Bevorzugt werden die Übertragungspausen in Abhängigkeit eines durch die Übertragung der elektrischen Daten oder der elektrischen Leistung hervorgerufenen Nebensprechsignals erkannt und erfasst.

Die im Hinblick auf die Messanordnung aufgeführten Vorteile und bevorzugten Ausgestaltungen sind sinngemäß auf das Verfahren zu übertragen und umgekehrt.

Ein Ausführungsbeispiel der Erfindung wird nachfolgend anhand der Figuren näher erläutert. Diese zeigen teilweise in stark vereinfachten Darstellungen:

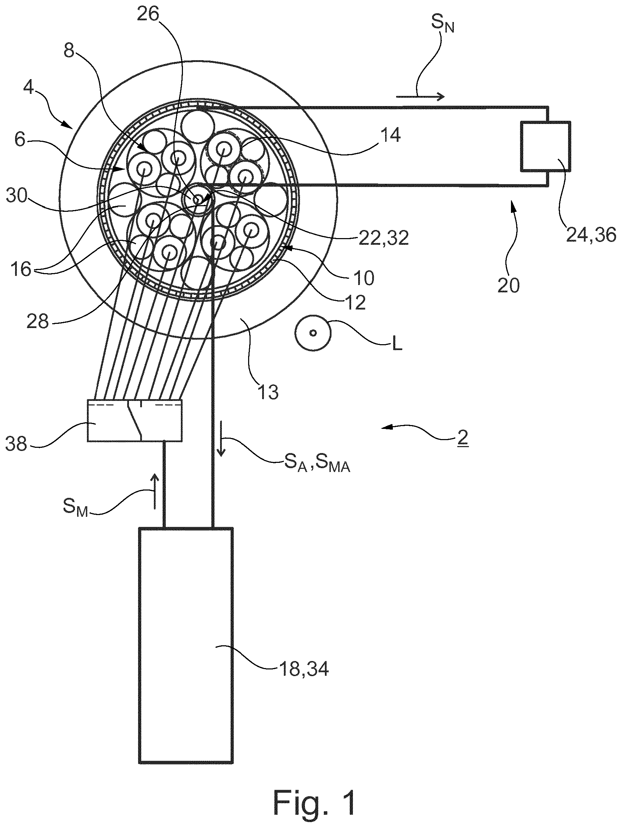

- Fig. 1: ein schematisches Blockschaltbild einer Messanordnung zur Überwachung eines Kabels.

In Fig. 1 ist ein Blockschaltbild einer Messanordnung 2 zur Überwachung eines sich in eine Längsrichtung L erstreckenden Kabels 4 dargestellt.

Das Kabel 4 weist einen Kabelkern 6 mit im Ausführungsbeispiel vier elektrischen Leitungselementen 8 auf. Die Leitungselemente 8 dienen einer elektrischen Datenübertragung oder einer elektrischen Leistungsübertragung. Im Ausführungsbeispiel ist das Kabel 4 als ein Cat5-Kabel zur Datenübertragung ausgebildet. Im Ausführungsbeispiel sind der Kabelkern 6 sowie der Außenschirm 12 gemeinsam von einem Schutzmantel 13 umgeben.

Der Kabelkern 6 ist an einer Außenseite 10 umfangsseitig von einem Außenschirm 12 umgeben. Je ein Leitungselement 8 weist ein ungeschirmtes Adernpaar 14, im Ausführungsbeispiel ein verseiltes Adernpaar 14 auf (in Fig. 1 durch die gestrichelte Umrandung gekennzeichnet). Zur Stabilisation und um eine vorzugsweise runde Querschnittsgeometrie zu erreichen, sind im Ausführungsbeispiel innerhalb des Kabelkerns 6 Füllelemente 16 angeordnet.

Weiterhin weist die Messanordnung 2 eine Signaleinheit 18 zur Einspeisung eines Messsignals S_{M} in den Kabelkern 6 auf. Im Ausführungsbeispiel ist die Signaleinheit 18 derart eingerichtet und ausgebildet, dass im Betrieb das Messsignal S_{M} in jedes Adernpaar 14 einspeisbar ist. Weiterhin ist die Signaleinheit 18 zur Erfassung eines Antwortsignals S_{A} ausgebildet.

Die Signaleinheit 18 ist zur Einspeisung des Messsignals S_{M} mit den elektrischen Leitungselementen 8, im Ausführungsbeispiel mit jeder Ader eines jeden Adernpaares 14 elektrisch verbunden.

Weiterhin ist eine Sensoreinheit 20 vorgesehen mit einer sich in Längsrichtung L erstreckenden Sensorleitung 22 sowie mit einer Überwachungseinheit 24. Die Sensorleitung 22 ist innerhalb des Kabelkerns 6, im Ausführungsbeispiel zentral innerhalb des Kabelkerns 6 angeordnet, sodass die Sensorleitung 22 von den Leitungselementen 8 umgeben ist. Die Sensorleitung 22 weist im Ausführungsbeispiel einen Innenleiter 26 sowie einen Außenleiter 28 auf, ist also nach Art einer Koaxialleitung ausgebildet. Zwischen dem Innenleiter 26 und dem Außenleiter 28 ist ein zustandsgrößenabhängiges, im Ausführungsbeispiel temperaturabhängiges Dielektrikum 30 angeordnet. Hierdurch ist eine Temperaturerfassung innerhalb des Kabelkerns 6 ermöglicht.

Die Sensorleitung 22 ist ebenfalls mit der Signaleinheit 18 elektrisch verbunden und dient als ein Rückleiter 32 für das Antwortsignal S_{A}. Zur Überwachung des Kabels 4, insbesondere zur Detektion von beschädigten Stellen entlang des Kabels 4 dient im Ausführungsbeispiel bevorzugt ein Verfahren, wie es bereits in der WO 2017/216061 A1 beschrieben ist. Aufgrund dessen ist das Antwortsignal S_{A} ein von dem Kabelkern 6 und insbesondere von den Leitungselementen 8 reflektierter Messsignalanteil S_{MA}, dessen - grob vereinfacht ausgedrückt - Überlagerung mit dem eingespeisten Messsignal S_{M} auf die Stelle und das Ausmaß einer Beschädigung der Leitungselemente 8 schließen lässt.

Das erfasste Antwortsignal S_{A} wird im Betrieb zur Auswertung an eine Auswerteeinheit 34 übertragen. Im Ausführungsbeispiel ist die Auswerteeinheit 34 ein Teil der Signaleinheit 18. Alternativ ist die Auswerteeinheit 34 und auch die Auswertung des erfassten Antwortsignals S_{A} ortsunabhängig und zeitunabhängig von der Messanordnung beziehungsweise der Erfassung des Antwortsignals S_{A}.

Die Überwachungseinheit 24 ist derart ausgebildet, dass sie Übertragungspausen in einer Übertragung von Daten durch die Leitungselemente 8 erkennt und überwacht. Hierzu ist die Überwachungseinheit 24 elektrisch sowohl mit dem Außenschirm 12 des Kabelkerns 6 als auch mit der Sensorleitung 22, im Ausführungsbeispiel mit dem Außenleiter 28 der Sensorleitung 22 verbunden. Hierdurch bildet sich eine koaxiale Ausgestaltung aus, in deren Zwischenraum die Leitungselemente 8 angeordnet sind. Im Betrieb, also während einer Übertragung durch die, insbesondere ungeschirmten Leitungselemente 8 wird somit ein Störsignal, im Ausführungsbeispiel ein Nebensprechsignal S_{N} in die Überwachungseinheit 24 eingekoppelt. Das Nebensprechsignal S_{N} steht somit stellvertretend für eine stattfindende Übertragung durch die Leitungselemente 8. Die Überwachungseinheit 24 weist zudem einen Komparator 36 auf. Der Komparator 36 dient einem Vergleich des eingekoppelten Nebensprechsignals S_{N} mit einem vorgegebenen und anwendungsspezifischen Vergleichswert. Übersteigt das Nebensprechsignal S_{N} den Vergleichswert, detektiert die Überwachungseinheit 24 eine stattfindende Übertragung und übermittelt dies an die Signaleinheit 18. Um die Übertragung durch die Leitungselemente 8 nicht zu stören und umgekehrt, um das Messsignal S_{M} sowie das Antwortsignal S_{A} durch übertragene Daten nicht zu verfälschen, erfolgt eine Einspeisung des Messsignals S_{M} und folglich eine Messung der einzelnen Leitungselemente 8 lediglich in den zuvor erwähnten Übertragungspausen.

Um alle innerhalb des Kabelkerns 6 angeordneten Leitungselemente 8 und insbesondere die Adernpaare 14 mit dem Messsignal S_{M} für eine Messung beaufschlagen zu können, weist die Signaleinheit 18 ein Umschaltelement 38, beispielsweise ein Halbleiter-Umschalter nach Art eines integrierten Schaltkreises (integrated circuit, IC) oder ein Hochfrequenzschaltelement auf. Das Umschaltelement 38 ist derart an die Signaleinheit 18 angeschlossen, sodass das Messsignal S_{M} eingangsseitig in das Umschaltelement 38 eingespeist wird. Ausgangsseitig ist das Umschaltelement jeweils an die einzelnen Adern der Adernpaare 14 sowie an den Innenleiter 26, den Außenleiter 28 und an den Außenschirm 12 angeschlossen. Das Umschaltelement 38 schaltet nun im Betrieb zur Messung das Messsignal S_{M} nachfolgend wechselbar auf jede Ader der Adernpaare 14, um somit jedes Leitungselement 8 durchzumessen. Als Rückleiter 32 dient im Ausführungsbeispiel jeweils die Sensorleitung 22. Alternativ dient jeweils eine Ader eines Adernpaares 14 als Rückleiter 32 für die zu messende andere Ader des Aderpaares 14. Tritt beispielsweise während einer Messung eine Übertragung auf, wird also die Übertragungspause unterbrochen, so ist die Signaleinheit 18 derart ausgebildet, dass sie sich das zuletzt durchgemessene Adernpaar 14 "merkt" und bei der nächsten Übertragungspause die Messung fortsetzt.

Die hier beschriebene Messanordnung kombiniert daher folgende Zustandsüberprüfungen:
a) Erfassen von Übertragungspausen anhand des Nebensprechsignals,
b) alternierendes Überprüfen der Leitungselemente (über eine "Reflektionsmessung", insbesonders gemäß dem in der WO 2017/216061 A1 beschriebenen Verfahren)
c) fakultative Detektion der Temperatur (über eine durch das Dielektrikum beeinflusste "Reflektionsmessung" zwischen Innenleiter und Außenleiter der Sensorleitung)

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen.

## Patentansprüche

1. Messanordnung (2), zur Überwachung eines sich in eine Längsrichtung erstreckenden Kabels (4), wobei das Kabel (4) aufweist:
- einen Kabelkern (6) mit zumindest einem elektrischen Leitungselement (8) zur Übertragung von elektrischen Daten oder elektrischer Leistung,
- eine Signaleinheit (18) zur Einspeisung eines Messsignals (S_{M}) in den Kabelkern (6) und zur Erfassung eines Antwortsignals (S_{A}), wobei die Signaleinheit (18) zur Einspeisung des Messsignals (S_{M}) mit dem zumindest einen Leitungselement (8) elektrisch verbunden ist,
wobei
- eine Sensoreinheit (20) vorgesehen ist mit einer sich in Längsrichtung erstreckenden Sensorleitung (22), die innerhalb des Kabelkerns (6) angeordnet ist,
**gekennzeichnet durch**
- eine Überwachungseinheit (24), die zur Erkennung von Übertragungspausen bei der Übertragung der elektrischen Daten oder der elektrischen Leistung ausgebildet ist, wobei
- die Signaleinheit (18) derart ausgebildet ist, dass im Betrieb in Abhängigkeit der erfassten Übertragungspausen das Messsignal (S_{M}) in das zumindest eine Leitungselement (8) eingespeist wird und das Antwortsignal (S_{A}) erfasst wird und zur Auswertung an eine Auswerteeinheit (34) übertragen wird.

2. Messanordnung (2) nach Anspruch 1,
wobei der Kabelkern (6) von einem Außenschirm (12) umgeben ist und der Außenschirm (12) über die Überwachungseinheit (24) mit der Sensorleitung (22) elektrisch verbunden ist und mittels der Überwachungseinheit (24) in Abhängigkeit eines in den Außenschirm (12) eingekoppelten Nebensprechsignals die Übertragung der elektrischen Daten oder der elektrischen Leistung erfassbar und überwachbar ist.

3. Messanordnung (2) nach einem der Ansprüche 1 oder 2,
wobei die Sensorleitung (22) einen Innenleiter (26) und einen Außenleiter (28) mit einem Dielektrikum (30) aufweist, welches von einer Zustandsgröße abhängig ist.

4. Messanordnung (2) nach Anspruch 3,
wobei der Außenleiter (28) sowohl mit der Signaleinheit (18) als auch mit der Überwachungseinheit (24) verbunden ist und zur Erfassung und Auswertung der Zustandsgröße ausgebildet ist.

5. Messanordnung (2) nach einem der Ansprüche 1 bis 4,
wobei der Kabelkern (6) mehrere Leitungselemente (8) aufweist, die jeweils mit der Signaleinheit (18) elektrisch verbunden sind und diese derart ausgebildet ist, dass in den Übertragungspausen das Messsignal (S_{M}) von der Signaleinheit (18) in ein jeweiliges Leitungselement (8) eingespeist wird.

6. Messanordnung (2) nach Anspruch 5,
wobei die Signaleinheit (18) ein Umschaltelement (38) aufweist, mittels dem die Leitungselemente (8) mit der Signaleinheit (18) verbunden sind, sodass das Messsignal (S_{M}) im Betrieb abwechselnd in die Leitungselemente (8) einspeisbar ist.

7. Messanordnung (2) nach einem der Ansprüche 1 bis 6 und nach Anspruch 2,
wobei die Überwachungseinheit (24) einen Komparator (36) zum Vergleich des in den Außenschirm (12) eingekoppelten Nebensprechsignals (S_{N}) mit einer vorgegebenen Vergleichspannung aufweist.

8. Messanordnung (2) nach einem der Ansprüche 1 bis 7,
wobei die Sensorleitung (22) als Rückleiter (32) für das Antwortsignal (S_{A}) dient.

9. Messanordnung (2) nach einem der Ansprüche 1 bis 8,
wobei das Antwortsignal (S_{A}) ein von dem Kabelkern (6) zur Signaleinheit (18) reflektierter Messsignalanteil (S_{MA}) ist.

10. Messanordnung (2) nach einem der Ansprüche 1 bis 9,
die derart ausgebildet ist, dass sie eine Übertragungsbeeinträchtigung detektiert, indem sie eine Laufzeit des Antwortsignals (S_{A}) erfasst und auswertet.

11. Messanordnung (2) nach Anspruch 10,
wobei die Signaleinheit (18) derart ausgebildet ist, dass im Zuge eines Messzyklus mehrere Einzelmessungen durchgeführt werden, wobei pro Einzelmessung das Messsignal (S_{M}) von der Signaleinheit (18) in die Leitungselemente (8) eingespeist wird, wobei bei einem Überschreiten eines vorgegebenen Schwellwerts infolge des reflektierten Messsignalanteils (S_{MA}) ein Stoppsignal erzeugt wird, wobei eine Laufzeit zwischen dem Einspeisen des Messsignals (S_{M}) und dem Stoppsignal ermittelt wird, und wobei vorzugsweise der Schwellwert zwischen den Einzelmessungen verändert wird.

12. Messanordnung (2) nach einem der Ansprüche 1 bis 11,
wobei das zumindest eine elektrische Leitungselement (8) ein ungeschirmtes Adernpaar (14), vorzugsweise ein verseiltes ungeschirmtes Adernpaar (14) aufweist.

13. Messanordnung (2) nach einem der Ansprüche 1 bis 12,
wobei die Sensorleitung (22) zentral im Kabelkern (6) angeordnet ist und von mehreren Leitungselementen (8) umgeben ist.

14. Verfahren zur Überwachung eines sich in eine Längsrichtung erstreckenden Kabels (4), wobei das Kabel (4) einen Kabelkern (6) mit zumindest einem elektrischen Leitungselement (8) zur Übertragung von elektrischen Daten oder elektrischer Leistung aufweist und
- eine Signaleinheit (18) vorgesehen ist, über die ein Messsignal (S_{M}) in den Kabelkern (6) eingespeist und ein Antwortsignal (S_{A}) erfasst wird, **dadurch gekennzeichnet, dass**
- Übertragungspausen in der Übertragung der elektrischen Daten oder der elektrischen Leistung erkannt werden und
- das Messsignals (S_{M}) in Abhängigkeit der erfassten Übertragungspausen in das zumindest eine Leitungselement (8) eingespeist wird und das Antwortsignal (S_{A}) erfasst wird und zur Auswertung an eine Auswerteeinheit (34) übertragen wird.

15. Verfahren nach Anspruch 14,
wobei die Übertragungspausen in Abhängigkeit eines durch die Übertragung der elektrischen Daten oder der elektrischen Leistung hervorgerufenen Nebensprechsignals (S_{N}) erfasst werden.

## Claims

1. Measuring arrangement (2), for monitoring a cable (4) extending in a longitudinal direction, the cable (4) having:
- a cable core (6) with at least one electrical line element (8) for transmitting electrical data or electrical power,
- a signal unit (18) for feeding a measuring signal (S_{M}) into the cable core (6) and for detecting a response signal (S_{A}), wherein the signal unit (18) for feeding the measuring signal (S_{M}) is electrically connected to the at least one line element (8),
wherein
- a sensor unit (20) is provided with a longitudinally extending sensor line (22), which is arranged inside the cable core (6),
**characterized by**
- a monitoring unit (24), which is designed to detect transmission pauses in the transmission of the electrical data or the electrical power, wherein
- the signal unit (18) is designed in such a way that, during operation, the measuring signal (S_{M}) is fed into the at least one line element (8) as a function of the detected transmission pauses and the response signal (S_{A}) is detected and transmitted to an evaluation unit (34) for evaluation.

2. Measuring arrangement (2) according to claim 1,
wherein the cable core (6) is surrounded by an outer sheath (12) and said outer sheath (12) is electrically connected to the sensor line (22) via the monitoring unit (24) and the transmission of the electrical data or the electrical power can be detected and monitored by means of the monitoring unit (24) as a function of a crosstalk signal coupled into the outer sheath (12).

3. Measuring arrangement (2) according to one of claims 1 or 2,
wherein the sensor line (22) has an inner conductor (26) and an outer conductor (28) with a dielectric (30), which is dependent on a state variable.

4. Measuring arrangement (2) according to claim 3,
wherein the outer conductor (28) is connected both to the signal unit (18) and to the monitoring unit (24) and is designed to detect and evaluate the state variable.

5. Measuring arrangement (2) according to one of claims 1 to 4,
wherein the cable core (6) has a plurality of line elements (8), each of which is electrically connected to the signal unit (18) and the latter is designed in such a way that in the transmission pauses the measuring signal (S_{M}) is fed from the signal unit (18) into a respective line element (8).

6. Measuring arrangement (2) according to claim 5,
wherein the signal unit has a switching element (38), by means of which the line elements (8) are connected to the signal unit (18), so that the measuring signal (S_{M}) can be fed alternately into the line elements (8) during operation.

7. Measuring arrangement (2) according to one of claims 1 to 6 and according to claim 2,
wherein the monitoring unit (24) has a comparator (36) for comparing the crosstalk signal (S_{N}) coupled into the outer sheath (12) with a predetermined comparison voltage.

8. Measuring arrangement (2) according to one of claims 1 to 7,
wherein the sensor line (22) serves as a return conductor for the response signal (SA).

9. Measuring arrangement (2) according to one of claims 1 to 8,
wherein the response signal (S_{A}) is a measuring signal component (S_{MA}) reflected from the cable core (6) to the signal unit (18).

10. Measuring arrangement (2) according to one of claims 1 to 9,
which is designed in such a way that it detects a transmission impairment by detecting and evaluating a propagation delay of the response signal (S_{A}).

11. Measuring arrangement (2) according to claim 10,
wherein the signal unit (18) is designed in such a way that a plurality of individual measurements are carried out in the course of a measurement cycle, wherein the measuring signal (S_{M}) is fed into the line elements (8) by the signal unit (18) for each individual measurement, wherein a stop signal is generated when a predetermined threshold value is exceeded as a result of the reflected measuring signal component (S_{MA}), wherein a propagation time between the feeding in of the measuring signal (S_{M}) and the stop signal is determined, and wherein preferably the threshold value is modified between the individual measurements.

12. Measuring arrangement (2) according to one of claims 1 to 11,
wherein the at least one electrical line element (8) has an unshielded pair of wires (14), preferably a twisted unshielded pair of wires (14).

13. Measuring arrangement (2) according to one of claims 1 to 12,
wherein the sensor line (22) is arranged centrally in the cable core (6) and is surrounded by a plurality of line elements (8).

14. Method for monitoring a cable (4) extending in a longitudinal direction, the cable (4) having a cable core (6) with at least one electrical line element (8) for transmitting electrical data or electrical power, and
- a signal unit (18) is provided, via which a measuring signal (S_{M}) is fed into the cable core (6) and a response signal (S_{A}) is detected,
**characterized in that**
- transmission pauses in the transmission of the electrical data or the electrical power are detected and
- the measuring signal (S_{M}) is fed into the at least one line element (8) as a function of the detected transmission pauses, and the response signal (S_{A}) is detected and transmitted to an evaluation unit (34) for evaluation.

15. Method according to claim 14,
wherein the transmission pauses are detected as a function of a crosstalk signal (S_{N}) caused by the transmission of the electrical data or the electrical power.

## Revendications

1. Dispositif de mesure (2), pour la surveillance d'un câble (4) s'étendant dans une direction longitudinale, le câble (4) comprenant :
- une âme de câble (6) avec au moins un élément de ligne (8) pour la transmission de données électriques ou de puissance électrique,
- une unité de signalisation (18) pour l'injection d'un signal de mesure (S_{M}) dans l'âme de câble (6) et pour la détection d'un signal de réponse (S_{A}), dans lequel l'unité de signalisation (18) est reliée électriquement à l'au moins un élément de ligne (8) pour l'injection du signal de mesure (S_{M}),
dans lequel
- une unité de détection (20) est prévue avec une ligne de détection (22) s'étendant dans la direction longitudinale, qui est disposée à l'intérieur de l'âme de câble (6),
**caractérisé par**
- une unité de surveillance (24), qui est conçue pour détecter des pauses de transmission lors de la transmission des données électriques ou de la puissance électrique, dans lequel
- l'unité de signalisation (18) est conçue de telle sorte qu'en fonctionnement, en fonction des pauses de transmission détectées, le signal de mesure (S_{M}) est injecté dans l'au moins un élément de ligne (8) et le signal de réponse (S_{A}) est détecté et transmis à une unité d'évaluation (34) pour évaluation.

2. Dispositif de mesure (2) selon la revendication 1,
dans lequel l'âme de câble (6) est entourée d'un blindage extérieur (12) et le blindage extérieur (12) est relié électriquement à la ligne de capteur (22) par l'intermédiaire de l'unité de surveillance (24) et la transmission des données électriques ou de la puissance électrique peut être détectée et contrôlée au moyen de l'unité de surveillance (24) en fonction d'un signal de diaphonie couplé dans le blindage extérieur (12).

3. Dispositif de mesure (2) selon l'une des revendications 1 ou 2,
dans lequel la ligne de capteur (22) comprend un conducteur intérieur (26) et un conducteur extérieur (28) avec un diélectrique (30), qui dépend d'une grandeur d'état.

4. Dispositif de mesure (2) selon la revendication 3,
dans lequel le conducteur extérieur (28) est relié aussi bien à l'unité de signalisation (18) qu'à l'unité de surveillance (24) et est conçu pour détecter et évaluer la grandeur d'état.

5. Dispositif de mesure (2) selon l'une des revendications 1 à 4,
dans lequel l'âme de câble (6) comprend un pluralité d'éléments de ligne (8), qui sont respectivement reliés électriquement à l'unité de signal (18) et celle-ci est conçue de telle sorte que, pendant les pauses de transmission, le signal de mesure (S_{M}) est injecté par l'unité de signal (18) dans un élément de ligne (8) respectif.

6. Dispositif de mesure (2) selon la revendication 5,
dans lequel l'unité de signalisation comprend un élément de commutation (38), au moyen duquel les éléments de ligne (8) sont reliés à l'unité de signalisation (18), de sorte que le signal de mesure (S_{M}) peut être injecté en alternance dans les éléments de ligne (8) pendant le fonctionnement.

7. Dispositif de mesure (2) selon l'une des revendications 1 à 6 et selon la revendication 2,
dans lequel l'unité de surveillance (24) comporte un comparateur (36) pour comparer le signal de diaphonie (S_{N}) injecté dans le blindage extérieur (12) avec une tension de comparaison prédéterminée.

8. Dispositif de mesure (2) selon l'une des revendications 1 à 7,
dans lequel la ligne de capteur (22) sert de conducteur de retour pour le signal de réponse (S_{A}).

9. Dispositif de mesure (2) selon l'une des revendications 1 à 8,
dans lequel le signal de réponse (S_{A}) est une composante de signal de mesure (S_{MA}) réfléchie par l'âme de câble (6) vers l'unité de signal (18).

10. Dispositif de mesure (2) selon l'une des revendications 1 à 9,
qui est conçu de telle sorte qu'il détecte une dégradation de la transmission en détectant et en évaluant un temps de propagation du signal de réponse (S_{A}).

11. Dispositif de mesure (2) selon la revendication 10,
dans lequel l'unité de signal (18) est conçue de telle sorte qu'un pluralité de mesures individuelles sont effectuées au cours d'un cycle de mesure, dans lequel le signal de mesure (S_{M}) est injecté par l'unité de signal (18) dans les éléments de ligne (8) pour chaque mesure individuelle, dans lequel un signal d'arrêt est généré en cas de dépassement d'une valeur seuil prédéterminée suite à la composante de signal de mesure réfléchie (S_{MA}), dans lequel un temps de propagation entre l'injection du signal de mesure (S_{M}) et le signal d'arrêt est déterminé, et dans lequel la valeur seuil est de préférence modifiée entre les mesures individuelles.

12. Dispositif de mesure (2) selon l'une des revendications 1 à 11,
dans lequel l'au moins un élément de ligne électrique (8) comporte une paire de fils non blindés (14), de préférence une paire de fils torsadés non blindés (14).

13. Dispositif de mesure (2) selon l'une des revendications 1 à 12,
dans lequel la ligne de capteur (22) est disposée au centre de l'âme de câble (6) et est entourée d'une pluralité éléments de ligne (8).

14. Procédé de surveillance d'un câble (4) s'étendant dans une direction longitudinale, dans lequel le câble (4) comprend une âme de câble (6) avec au moins un élément ligne (8) pour la transmission de données électriques ou de puissance électrique, et
- une unité de signalisation (18) est prévue, par l'intermédiaire de laquelle un signal de mesure (S_{M}) est injecté dans l'âme de câble (6) et un signal de réponse (S_{A}) est détecté,
**caractérisé en ce que**
- des pauses de transmission sont détectées dans la transmission des données électriques ou de la puissance électrique et
- le signal de mesure (S_{M}) est injecté dans l'au moins un élément de ligne (8) en fonction des pauses de transmission détectées et le signal de réponse (S_{A}) est détecté et transmis à une unité d'évaluation (34) pour évaluation.

15. Procédé selon la revendication 14,
dans lequel les pauses de transmission sont détectées en fonction d'un signal de diaphonie (S_{N}) provoqué par la transmission des données électriques ou de la puissance électrique.
